(19) Europäisches Patentamt
European Patent Office
Office européen des brevets

(11) **EP 2 404 186 B1**

(12) **EUROPÄISCHE PATENTSCHRIFT**

(45) Veröffentlichungstag und Bekanntmachung des Hinweises auf die Patenterteilung:
**05.12.2012 Patentblatt 2012/49**

(21) Anmeldenummer: **10700841.9**

(22) Anmeldetag: **11.01.2010**

(51) Int Cl.:
**G01R 31/36** (2006.01)        **B60R 16/03** (2006.01)

(86) Internationale Anmeldenummer:
**PCT/EP2010/050217**

(87) Internationale Veröffentlichungsnummer:
**WO 2010/099990 (10.09.2010 Gazette 2010/36)**

(54) **Verfahren und Vorrichtung zur Ermittlung einer charakteristischen Größe zur Erkennung der Bordnetzstabilität**

Method and device for determining a characteristic quantity for detecting the onboard supply system stability

Procédé et dispositif de détermination d'une grandeur caractéristique afin de détecter la stabilité du réseau de bord

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **03.03.2009 DE 102009001300**

(43) Veröffentlichungstag der Anmeldung:
**11.01.2012 Patentblatt 2012/02**

(73) Patentinhaber: **Robert Bosch GmbH**
**70442 Stuttgart (DE)**

(72) Erfinder: **MOTZ, Juergen**
**71711 Steinheim an der Murr (DE)**

(56) Entgegenhaltungen:
EP-A2- 0 992 801        DE-A1- 3 901 680
DE-A1- 10 122 767        DE-A1- 10 309 322
DE-A1- 10 337 064        DE-A1-102004 004 172
DE-A1-102005 026 866        DE-A1-102005 050 563
DE-A1-102008 034 914

• BARRUEL ET AL: "Stability Approach for Vehicles DC Power Network: Application to Aircraft On-board System" POWER ELECTRONICS SPECIALISTS CONFERENCE, 2005. PESC '05. IEEE 36TH, IEEE, PISCATAWAY, NJ, USA LNKD- DOI:10.1109/PESC. 2005.1581776, 1. Januar 2005 (2005-01-01), Seiten 1163-1169, XP031000302 ISBN: 978-0-7803-9033-1

**Beschreibung**

Stand der Technik

Die Erfindung geht aus von einem Verfahren und einer Vorrichtung zur Ermittlung einer charakteristischen Größe zur Erkennung einer Bordnetzstabilität nach der Gattung der unabhängigen Ansprüche. Aus der EP 1 207 297 A2 sind bereits ein Verfahren und eine Anordnung zur Ermittlung der Startfähigkeit einer Starterbatterie eines Verbrennungsmotors bekannt. Hierzu werden folgende Schritte durchlaufen:

- Feststellung eines die Startfähigkeit beeinflussenden Ladezustands der Starterbatterie,
- Feststellung einer die Startfähigkeit beeinflussenden Temperatur,
- Berechnung oder Feststellung eines mittleren Spannungsabfalls der Starterbatterie während der Startphase und
- Abschätzung der Startfähigkeit der Starterbatterie durch Vergleich des berechneten oder festgestellten mittleren Spannungsabfalls mit einem Schwellwert.

Das Verfahren und diese Anordnung eignen sich zur Ermittlung der Startfähigkeit einer Starterbatterie, nicht jedoch für Aussagen hinsichtlich der zu erwartenden Bordnetzstabilität.

Aus der DE 103 28 055 A1 ist ein Zustandsgrößen- und Parameterschäter mit mehreren Teilmodellen für einen elektrischen Energiespeicher bekannt Dieser bestimmt Zustandsgrößen und Parameter eines Batteriemodells für den gesamten Arbeitsbereich, indem auf unterschiedliche mathematische Teilmodelle zurückgegriffen wird, die für unterschiedliche Arbeits- und/oder Frequenzbereiche des Energiespeichers gelten.

Aus der EP-A 992 801 sind bereits ein Verfahren und eine Vorrichtung zur Ermittlung des Bordnetzzustands eines Kraftfahrzeugs bekannt. Die im Bordnetz auftretende Spannung wird je nach Betriebssituation in einen gefilterten Spannungswert oder einen zeitlich gemittelten Spannungswert umgewandelt. Der derart umgewandelte Spannungswert wird dann als Batteriespannung daraufhin überprüft, ob ein kritischer Bordnetzzustand vorliegt. Die Batteriespannung ist von zustandsirrelevanten Spannungseinbrüchen befreit, sodass Fehleinschätzungen des Bordnetzzustands vermieden werden können.

Aus der DE-A-10 2005 026 866 ist bereits ein Verfahren zum Überwachen einer Spannung einer Batterie eines Kraftfahrzeugs und ein entsprechendes Ladezustandsmesssystem bekannt. Zur Erhöhung der Lebensdauer der Batterie wird vorgeschlagen, dass ein niedrigster Spannungswert erfasst und einem Steuergerät des Kraftfahrzeugs zugeleitet wird.

Es ist Aufgabe der vorliegenden Erfindung, ohne zusätzlichen Hardwareaufwand auf einfache Art und Weise eine charakteristische Größe zu ermitteln, anhand der leicht Aussagen zur Bordnetzstabilität getroffen werden können. Diese Aufgabe wird gelöst durch die Merkmale der unabhängigen Ansprüche.

Vorteile der Erfindung

Das erfindungsgemäße Verfahren und die erfindungsgemäße Vorrichtung zur Ermittlung einer charakteristischen Größe zur Erkennung der Bordnetzstabilität haben demgegenüber den Vorteil, dass eine indirekte Bestimmung des maximalen Startstroms durch direkte Messung der Batteriespannung in dem benötigten Bereich mit vergleichsweise geringem Aufwand erfassbar ist. Dies ist gegenüber einer direkten Erfassung des Startstroms mit geringerem Hardwareaufwand möglich, so dass eine Kostensenkung bei Bereitstellung der vollen Funktion erreicht werden kann. Anhand der indirekten Erfassung des Startstroms muss auf der anderen Seite keine große Sicherheitsreserve vorgehalten werden, da ein mit den entsprechenden Umgebungsbedingungen abgeglichenes Stromprofil sich durch hohe Genauigkeit auszeichnet. Die indirekte Messmethode des Startstroms über die Ermittlung der Batteriespannung hat darüber hinaus einen Vorteil, dass kein sehr großer Strommessbereich mehr abgedeckt werden muss, um den Kurzschlussstrom des Startermotors unmittelbar zu erfassen.

In einer zweckmäßigen Weiterbildung ist vorgesehen, dass der Startstrom unter Verwendung eines Batteriemodell ermittelt wird. Zweckmäßigerweise werden die Parameter bzw. Zustandsgrößen des Batteriemodells ständig aktualisiert mit Hilfe einer Erfassung von vorzugsweise Strom, Spannung und Temperatur. Dadurch lässt sich die Genauigkeit der Startstromermittlung weiter verbessern. Der Startstrom wird bestimmt unter Verwendung des Innenwiderstands der Batterie, der wiederum von der Temperatur der Batterie, dem Ladezustand (SOC) der Batterie und gegebenenfalls vom Alterungszustand (SOH) der Batterie abhängigen kann.

In einer zweckmäßigen Weiterbildung ist vorgesehen, dass nach erkanntem Motorstart die Batteriespannung erfasst wird. Vorzugsweise wird ein Motorstart erkannt, indem der Batteriestrom mit einem Grenzwert verglichen wird. Übersteigt betragsmäßig der Batteriestrom diesen Grenzwert, so wird auf den Beginn des Startvorgangs geschlossen und die entsprechende Batteriespannung erfasst.

In einer zweckmäßigen Weiterbildung ist vorgesehen, dass nach erkanntem Motorstart die Stromerfassung deaktiviert wird. Damit können Beschädigungen der Stromerfassungseinrichtung sicher vermieden werden.

In einer zweckmäßigen Weiterbildung ist vorgesehen, dass die charakteristische Größe zur Ermittlung der Bordnetzstabilität berechnet wird in Abhängigkeit vom ermittelten Startstrom. Dies erfolgt mit Hilfe bestimmter Batteriemodellgrößen. Vorzugsweise wird neben dem Startstrom auch der Ladezustand der Batterie zur Bestimmung der charakteristischen Größe zur Erkennung der Bordnetzstabilität herangezogen. Dabei handelt es sich um die zu erwartende Minimalspannung. Diese zu erwartende Minimalspannung kann nun vorzugsweise in einem anderen Steuergerät, wie beispielsweise dem Energiemanagementsteuergerät mit einem Grenzwert verglichen werden. Liegt die erwartete Minimalspannung unterhalb des Grenzwerts, so könnte das Energiemanagementsteuergerät weitere Stopp-Vorgänge im Rahmen einer Start/Stopp-Steuerung unterbinden. Damit kann sichergestellt werden, dass die minimale Bordnetzspannung nicht unter einen kritischen Wert absinkt, der die Versorgung der angeschlossenen elektrischen Verbraucher nicht mehr sicherstellt.

Weitere zweckmäßige Weiterbildungen ergeben sich aus weiteren abhängigen Ansprüchen und aus der Beschreibung.

Zeichnung

Ein Ausführungsbeispiel des erfindungsgemäßen Verfahrens und der erfindungsgemäßen Vorrichtung zur Ermittlung einer charakteristischen Größe zur Erkennung der Bordnetzstabilität ist in der Zeichnung dargestellt und wird nachfolgend näher erläutert.

Es zeigen:

die Figur 1 ein Blockschaltbild der erfindungsgemäßen Vorrichtung,
die Figur 2 typische Strom- bzw. Spannungsverläufe beim Motorstart sowie
die Figur 3 ein Flussdiagramm des entsprechenden Verfahrens zur Ermittlung einer charakteristischen Größe zur Erkennung der Bordnetzstabilität.

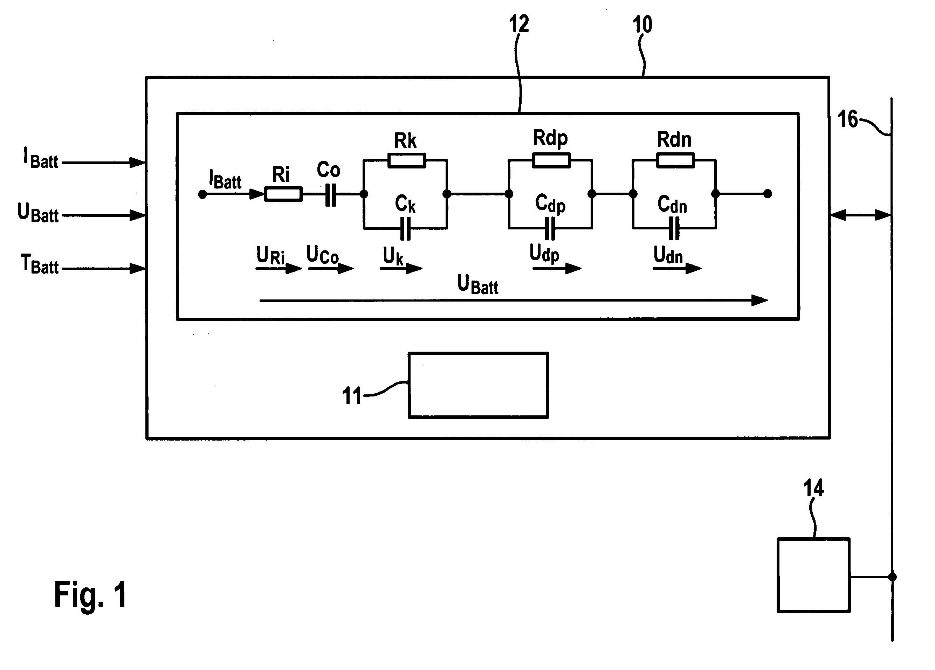

Einer Vorrichtung 10 zur Ermittlung einer charakteristischen Größe $U_{min}$ zur Erkennung der Bordnetzstabilität sind ein Batteriestrom $I_{Batt}$, eine Batteriespannung $U_{Batt}$ sowie eine für die Batterietemperatur charakteristische Temperatur $T_{Batt}$ zugeführt. Die Vorrichtung 10 umfasst ferner eine Recheneinheit 11 und ein Batteriemodell 12. Welches Batteriemodell 12 in der Vorrichtung 10 eingesetzt wird, ist für die Erfindung nicht wesentlich. Es soll jedenfalls allgemein dazu dienen, aus einer gemessenen Batteriespannung $U_{Batt}$ den korrespondierenden Batteriestrom $I_{Batt}$ zu ermitteln. Das in Figur 1 gezeigte Batteriemodell 12 lehnt sich beispielhaft an das Ersatzschaltbild einer Batterie während des Entladevorgangs bei niedrigen Frequenzen an wie in der DE 103 28 055 A1 beschrieben. Die Ermittlung der in dem Batteriemodell 12 gezeigten Größen Uc0, Uk, Udp, Udn, Rk, Rdp, Rdn, Ri erfolgt beispielsweise durch den in der DE 103 28 055 A1 beschriebenen Zustands- und Parameterschätzer. Die Vorrichtung 10 ist vorzugsweise über ein Bussystem 16 mit einem weiteren Steuergerät, beispielsweise ein Energiemanagementsteuergerät 14, verbunden.

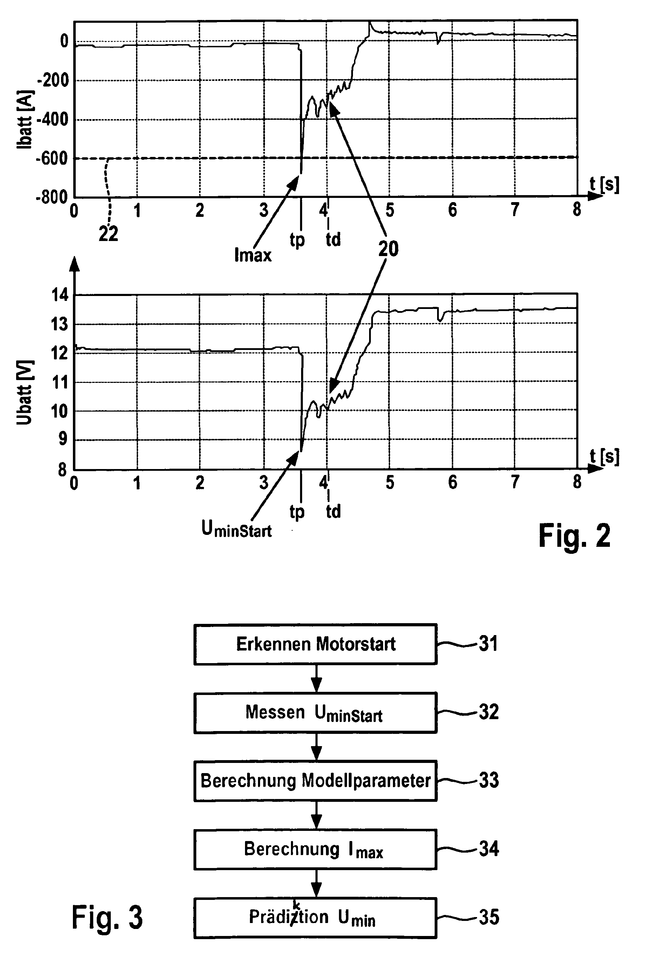

In der Figur 2 sind charakteristische Verläufe des Batteriestroms $I_{Batt}$ bzw. der Batteriespannung $U_{Batt}$ beim Startvorgang in Abhängigkeit von der Zeit gezeigt. Mit Beginn des Startvorgangs steigt der Batteriestrom $I_{Batt}$ vom Wert nahe Null zum Zeitpunkt tp auf einen betragsmäßig sehr hohen Wert an, um dann in einer Durchdrehphase 20 des Startermotors zum Zeitpunkt td wieder betragsmäßig abzunehmen. Denn durch einen zunehmenden Aufbau einer Induktionsspannung im Startermotor verringert sich der Batteriestrom $I_{Batt}$. In dieser Phase sinkt der Strom $I_{Batt}$ wieder unter eine Messbereichsgrenze 22 einer nicht eigens dargestellten Messeinrichtung für den Batteriestrom $I_{Batt}$. Der korrespondierende Spannungsverlauf $U_{Batt}$ zeigt, dass beim Startvorgang die Batteriespannung $U_{Batt}$ zum Zeitpunkt tp auf eine minimale Startspannung $U_{minStart}$ einbricht, um dann korrespondierend zum Stromverlauf $I_{Batt}$ über die Durchdrehphase 20 zum Zeitpunkt td anschließend auf einen nahezu konstanten Wert anzusteigen.

Die prinzipielle Betriebsweise der Vorrichtung 10 wird anhand des Flussdiagramms gemäß Figur 3 näher erläutert.

Das Verfahren zur Ermittlung einer charakteristischen Größe $U_{min}$ zur Erkennung der Bordnetzstabilität umfasst fünf Schritte 31 bis 35. In einem ersten Schritt 31 wird der Motorstart vorzugsweise eines Kraftfahrzeugs erkannt. Erfolgt ein Motorstart, so wird zum Zeitpunkt tp eine minimale Startspannung $U_{minStart}$ gemessen (zweiter Schritt 32). Parallel oder daran anschließend werden die Modellparameter P bzw. die Zustandsgrößen Z des Batteriemodells 12 neu berechnet (dritter Schritt 33), bevorzugt während der Durchdrehphase 20 zum Zeitpunkt td. Unter Zuhilfenahme des Batteriemodells 12 und der erfassten minimalen Startspannung $U_{minStart}$ wird der zugehörige betragsmäßig maximale Startstrom $I_{max}$ berechnet (vierter Schritt 34). Im fünften Schritt 35 wird die charakteristische Größe $U_{min}$ zur Erkennung der Bordnetzstabilität ermittelt Nachfolgend werden die einzelnen Schritte noch genauer beschrieben.

Zur Reduzierung des Kraftstoffverbrauchs verbrennungsmotorisch angetriebener Fahrzeuge haben sich sogenannte Start/Stopp-Systeme etabliert. Unter gewissen Bedingungen wird bei Stillstand der Verbrennungsmotor abgeschaltet. Allerdings muss die elektrische Energieversorgung durch einen ausreichenden Ladezustand einer elektrischen Batterie sichergestellt werden, so dass ein elektrisch betriebener Startermotor den Verbrennungsmotor starten kann. Außerdem müssen auch weitere elektrische Verbraucher selbst nach längeren Standzeiten ausreichend mit elektrischer Energie versorgt werden. Hierzu berücksichtigt das Energiemanagement bei Start/Stopp-Systemen in Fahrzeugen in der Regel die prädizierte minimale Batteriespannung $U_{min}$ bei einem Startvorgang, um eine störungsfreie Funktion der Steuergeräte sicher zu stellen. Ist die prädizierte Batteriespannung $U_{min}$ zu gering, so könnte es zu Funktionsstörungen kommen. Dies würde dann das Energiemanagement verhindern beispielsweise durch Unterbindung eines Motorstopps, der ansonsten im Rahmen der Start/Stopp-Funktion erfolgt wäre. Ein solches Energiemanagement könnte in einem Steuergerät 14 realisiert werden, dem die charakteristische Größe $U_{min}$ zur Erkennung einer Bordnetzstabilität zugeführt ist. Zur Prädiktion der minimalen Batteriespannung $U_{min}$ wird ein an die jeweiligen Umgebungsbedingungen angepasstes Stromprofil verwendet. Maßgeblich hierfür ist der maximale Startstrom $I_{max}$ während der Kurzschlussphase des Startvorgangs zum Zeitpunkt tp.

Erfindungsgemäß ist zur Ermittlung der charakteristischen Größe $U_{min}$ zur Erkennung einer Bordnetzstabilität eine indirekte Bestimmung des betragsmäßig maximalen Startstroms $I_{max}$ durch Messung der minimalen Startspannung U-$_{minStart}$ vorgesehen. Mithilfe der zum Zeitpunkt tp gemessenen minimalen Startspannung $U_{minStart}$ wird über das Batteriemodell 12 der korrespondierende Startstrom $I_{max}$ bestimmt. Da die Spannung $U_{Batt}$ in dem benötigten Bereich mit vergleichsweise geringem Aufwand messbar ist, der Strom $I_{Batt}$ jedoch in der Kurzschlussphase des Startvorgangs betragsmäßig sehr groß werden kann (bei einem PKW ca. 700A bis 1000A, bei einem NKW bis zu 2000A) und dadurch der nötige Hardwareaufwand zur Strommessung in diesem Bereich deutlich erhöht wäre, kann bei der indirekten Bestimmung des Startstroms $I_{max}$ eine Kostensenkung bei Bereitstellung der vollen Funktionalität erreicht werden.

Die Vorrichtung 10 dient der Durchführung der fünf Verfahrensschritte 31 bis 35 gemäß Figur 3. Diese Vorrichtung 10 könnte Bestandteil eines Batteriesensors sein, der den Batteriestrom $I_{Batt}$, die Batteriespannung $U_{Batt}$ und vorzugsweise auch die Temperatur der Batterie $T_{Batt}$ erfasst und daraus charakteristische Größen der Batterie wie Ladezustand, Alterung etc. ermittelt. Dies erfolgt unter Verwendung eines beispielhaft in Figur 1 gezeigten Batteriemodells 12. Dieses lehnt sich an das Ersatzschaltbild einer Batterie während des Entladevorgangs bei niedrigen Frequenzen an wie in der DE 103 28 055 A1 beschrieben. Die Ermittlung der in dem Batteriemodell 12 gezeigten Größen Uc0, Uk, Udp, Und - zusammenfassend auch als Zustandsgrößen Z bezeichnet - sowie Rk, Rdp, Rdn, Ri - zusammenfassend als Modellparameter P bezeichnet - erfolgt beispielsweise durch den in der DE 103 28 055 A1 beschriebenen Zustands- und Parameterschätzer.

Gemäß dem ersten Schritt 31 wird der Zeitpunkt des Motorstarts anhand des vom Startermotor gezogenen Batteriestroms $I_{Batt}$ bestimmt. Hierzu vergleicht die Vorrichtung 10 den erfassten Batteriestrom $I_{Batt}$ mit einem Grenzwert $I_{Grenz}$.

Überschreitet der Batteriestrom $I_{Batt}$ betragsmäßig den Grenzwert $I_{Grenz}$, so wird auf die Einleitung eines Motorstarts geschlossen. In der Kurzschlussphase des Startvorgangs steigt der Batteriestrom $I_{Batt}$ betragsmäßig kurzzeitig auf sehr hohe Werte an, da der Startermotor noch steht und keine Induktionsspannung vorliegt.

Wird durch Vergleich des Batteriestroms $I_{Batt}$ mit dem Grenzwert $I_{Grenz}$ auf einen Motorstart geschlossen, so wird der zweite Schritt 32 eingeleitet. In diesem wird die minimale Batteriespannung $U_{minStart}$ während des Startvorgangs erfasst und für eine spätere Berechnung des betragsmäßig maximalen Startstroms $I_{max}$ zwischengespeichert. Die minimale Batteriespannung $U_{minStart}$ während des Startvorgangs ist in Figur 2 mit einem Pfeil angedeutet Tp ist hierbei der Zeitpunkt, bei dem die minimale Batteriespannung $U_{minStart}$ während der Kurzschlussphase gemessen wird.

Das Erkennen eines Motorstarts gemäß dem ersten Schritt 31 kann auch dazu genutzt werden, ab diesem Zeitpunkt die Stromerfassung für eine bestimmte Dauer zu deaktivieren, um Beschädigungen zu vermeiden. Ebenso könnte der Zeitpunkt des Motorstarts auch dazu verwendet werden, ab diesem Zeitpunkt eine Anpassung der Modellparameter P (Rk, Rdp, Rdn, Ri) und Zustandsgrößen Z (Uc0, Uk, Udp, Und) des Batteriemodells 12 für eine bestimmte Zeitspanne auszusetzen, da der Strom $I_{Batt}$ den zur Verfügung stehenden Messbereich der Stromerfassung überschreitet. Die Batteriespannung $U_{Batt}$ wird jedoch weiterhin erfasst Die niedrigste Spannung $U_{minStart}$ während des Motorstarts zum Zeitpunkt tp wird gespeichert und für die spätere Stromberechnung $I_{max}$ verwendet Nach der Kurzschlussphase beginnt sich der Startermotor zu drehen und durch Aufbau einer Induktionsspannung im Motor verringert sich wieder der Strom. In dieser Phase sinkt der Strom $I_{Batt}$ wieder unter die Messbereichsgrenze 22.

Vorzugsweise in dieser sich an den Startvorgang anschließenden Phase, insbesondere während der sogenannten Durchdrehphase 20 des Startermotors, werden die Modellparameter P und Zustandsgrößen Z des Batteriemodells 12 aktualisiert, was in Schritt 33 erfolgt. Hierbei wird insbesondere der Innenwiderstand Ri der Batterie bestimmt zum Zeitpunkt td. Der Zeitpunkt td liegt kurz nach tp, dem Zeitpunkt des Auftretens der minimalen Batteriespannung $U_{minStart}$. Der Zeitpunkt td liegt vorzugsweise innerhalb der Durchdrehphase 20, jedenfalls ist er so gewählt, dass die Modellparameter P bzw. Zustandsgrößen Z sicher aktualisiert werden können, beispielsweise unter Messung der Größen $U_{Batt}$, $I_{Batt}$ und/oder $T_{Batt}$ zum Zeitpunkt td. Ein entsprechendes Vorgehen ist beispielsweise in der DE 103 28 055 A1 ausgeführt. Beispielhaft für ein Batteriemodell 12 werden im dritten Schritt die Größen Uc0, Uk, Udp, Udn - die Zustandsgrößen Z - sowie Rk, Rdp, Rdn, Ri - die Modellparameter P - ermittelt durch den entsprechenden Zustands- und Parameterschätzer.

**EP 2 404 186 B1**

Anhand des so aktualisierten Batteriemodells 12 ermittelt die Recheneinheit 11 im vierten Schritt 34 den zugehörigen Startstrom $I_{max}$ beispielsweise - je nach Batteriemodell 12 unterschiedlich - durch die Beziehung:

$$I_{Batt}(tp) = I_{max}(tp) = [U_{Batt}(tp) - Uc0(tp) - Uk(tp) - Udp(tp) - Udn(tp)]/Ri(td)$$

mit

tp = Zeitpunkt, bei dem die minimale Spannung $U_{minStart}$ während der Kurzschlussphase bzw. Startphase gemessen wird,
td = Zeitpunkt kurz nach tp, an dem der Innenwiderstand Ri der Batterie bestimmt werden kann unter Erfassung von Strom $I_{Batt}$ und Spannung $U_{Batt}$ zum Zeitpunkt td.

Im fünften Schritt 35 wird nun die charakteristische Größe $U_{min}$ zur Erkennung der Bordnetzstabilität ermittelt. Hierzu wird die prädizierte minimale Batteriespannung $U_{min}$ berechnet. Dies erfolgt zum einen unter Rückgriff auf die im vierten Schritt 34 berechneten maximalen Strom $I_{max}$, zum anderen unter Verwendung weiterer Größen des Batteriemodells wie beispielsweise der Ladezustand SOC bzw. die erfasste Temperatur $T_{Batt}$.
Die charakteristische Größe $U_{min}$ lässt sich beispielsweise nach folgender Gleichung berechnen:

$$U_{min} = Uc0 + Uk(ts, Istop) + Udp(ts, Istop) + Udn(ts, Istop) + Ri * I_{max}$$

Wobei Uk, Udp, Und abhängig von der zu erwartenden durchschnittlichen Stoppdauer ts und des zu erwartenden Batteriestroms Istop während der Stoppphase Istop extrapoliert werden.
Es ist eine kontinuierliche Abschätzung der charakteristische Größe $U_{min}$ vorgesehen. So ist $U_{min}$ auch vor den Stoppphasen interessant, insbesondere wenn sich die Betriebsparameter zwischen den Starts ändern.
Diese charakteristische Größe $U_{min}$ kann mit einem Grenzwert $U_{minGrenz}$ verglichen werden. Ist die charakteristische Größe $U_{min}$ unter diesem Grenzwert $U_{minGrenz}$, so sind die elektrischen Verbraucher des Bordnetzes nicht mehr ausreichend mit elektrischer Energie versorgt, so dass zukünftig ein Abschalten des Motors im Start/Stopp-Betrieb unterbleiben wird. Die genannte Auswertung könnte beispielsweise in dem Steuergerät 14, beispielsweise das Energiemanagementsteuergerät, vorgenommen werden, in dem auch die Start/Stopp-Funktion integriert wäre.
Die beschriebene Funktionalität könnte beispielsweise in einem Batteriesensor integriert sein. Solche Batteriesensoren sind in der Regel in der Nähe der Batterie angeordnet und erfassen unmittelbar die Batteriespannung $U_{Batt}$, den Batteriestrom $I_{Batt}$, sowie die Batterietemperatur $T_{Batt}$ und berechnen daraus für die Batterie charakteristische Größen wie den Ladezustand. Hier könnte auch der entsprechende Algorithmus gemäß Figur 3 implementiert sein, so dass in dem Batteriesensor auch die charakteristische Größe $U_{min}$ ermittelt wird. Dies könnte prinzipiell jedoch auch räumlich getrennt von einer Batteriezustandserkennung erfolgen und beispielsweise in dem Steuergerät 14 selbst implementiert sein.

**Patentansprüche**

1.  Verfahren zur Ermittlung einer charakteristischen Größe ($U_{min}$) zur Erkennung der Bordnetzstabilität, umfassend folgende Schritte:

    - Erkennen eines Motorstarts,
    - Erfassen der Batteriespannung ($U_{minStart}$) während des Motorstarts,
    - Berechnung eines korrespondierenden Startstroms ($I_{max}$) aus der erfassten Batteriespannung ($U_{minStart}$) mit Hilfe eines Batteriemodells (12),
    - Ermitteln zumindest einer charakteristischen Größe ($U_{min}$) in Form einer Prädiktion einer zu erwartenden Bordnetzspannung unter Verwendung des Batteriemodells (12) und des berechneten Startstroms ($I_{max}$).

2.  Verfahren nach Anspruch 1, **dadurch gekennzeichnet, dass** in einem weiteren Schritt nach Erkennen des Motorstarts Parameter und/oder Zustandsgrößen des Batteriemodells (12) aktualisiert werden.

**3.** Verfahren nach einem der vorhergehenden Ansprüche, **dadurch gekennzeichnet, dass** nach Erkennen des Motorstarts die minimale Batteriespannung ($U_{minStart}$) während des Startvorgangs ermittelt wird.

**4.** Verfahren nach einem der vorhergehenden Ansprüche, **dadurch gekennzeichnet, dass** der Startstrom ($I_{max}$) unter Verwendung eines Innenwiderstands (Ri) der Batterie ermittelt wird.

**5.** Verfahren nach einem der vorhergehenden Ansprüche, **dadurch gekennzeichnet, dass** der Innenwiderstand (Ri) der Batterie ermittelt wird unter Erfassung von Strom ($I_{Batt}$) und Spannung ($U_{Batt}$), vorzugsweise zeitlich kurz nach einem Zeitpunkt (tp) des Auftretens der minimalen Batteriespannung ($U_{minStart}$).

**6.** Vorrichtung zur Ermittlung einer charakteristischen Größe ($U_{min}$) zur Erkennung der Bordnetzstabilität, umfassen:

eine Einrichtung (10) konfiguriert zum Erkennen eines Motorstarts (11),
eine Einrichtung (10) konfiguriert zum Messen einer Batteriespannung ($U_{minStart}$) während des Motorstarts,
eine Einrichtung (11) konfiguriert zur Berechnung eines korrespondierenden Startstroms ($I_{max}$) aus der gemessenen Batteriespannung ($U_{minStart}$) mit Hilfe eines Batteriemodells (12),
eine Einrichtung (11) konfiguriert zum Ermitteln zumindest einer charakteristischen Größe ($U_{min}$) in Form einer Prädiktion einer zu erwartenden Bordnetzspannung unter Verwendung des Batteriemodells (12) und des berechneten Startstroms ($I_{max}$).

**7.** Vorrichtung nach Anspruch 6, **gekennzeichnet durch** eine Einrichtung (10) konfiguriert zur Aktualisierung zumindest eines Parameters und/oder einer Zustandsgröße des Batteriemodells (12).

**8.** Vorrichtung nach einem der vorhergehenden Ansprüche 6 oder 7, **gekennzeichnet durch** eine Einrichtung (10) konfiguriert zur Erfassung der minimalen Batteriespannung ($U_{minStart}$) während des Startvorgangs.

**9.** Vorrichtung nach einem der vorhergehenden Ansprüche 6 bis 8, **gekennzeichnet durch** eine Einrichtung (11) konfiguriert zur Ermittlung des Startstroms ($I_{max}$) unter Verwendung eines Innenwiderstands (Ri) der Batterie.

**10.** Vorrichtung nach einem der vorhergehenden Ansprüche 6 bis 9, **gekennzeichnet durch** eine Einrichtung (11) konfiguriert zur Ermittlung eines Innenwiderstands (Ri) der Batterie unter Erfassung von Strom ($I_{Batt}$) und Spannung ($U_{Batt}$), vorzugsweise zeitlich kurz nach einem Zeitpunkt (tp) des Auftretens der minimalen Batteriespannung ($U_{minStart}$).

**Claims**

**1.** Method for determining a characteristic variable ($U_{min}$) for detecting the stability of an on-board power system, comprising the following steps:

- detection of starting of the engine,
- measurement of the battery voltage ($U_{minStart}$) during the starting of the engine,
- calculation of a corresponding starting current ($I_{max}$) from the measured battery voltage ($U_{minStart}$) using a battery model (12),
- determination of at least one characteristic variable ($U_{min}$) in the form of a prediction of an expected on-board power system voltage using the battery model (12) and the calculated starting current ($I_{max}$).

**2.** Method according to Claim 1, **characterized in that** in a further step after detection of the starting of the engine, parameters and/or state variables of the battery model (12) are updated.

**3.** Method according to one of the preceding claims, **characterized in that** after detection of the starting of the engine, the minimum battery voltage ($U_{minStart}$) is determined during the starting process.

**4.** Method according to one of the preceding claims, **characterized in that** the starting current ($I_{max}$) is determined using an internal resistance (Ri) of the battery.

**5.** Method according to one of the preceding claims, **characterized in that** the internal resistance (Ri)of the battery is determined by measuring the current ($I_{Batt}$) and the voltage ($U_{Batt}$), preferably shortly after a time (tp) of occurrence of the minimum battery voltage ($U_{minStart}$).

6. Device for determining a characteristic variable ($U_{min}$) for detecting the stability of the on-board power system, comprising:

an apparatus (10) configured to detect starting (11) of the engine,
an apparatus (10) configured to measure a battery voltage ($U_{minStart}$) during starting of the engine,
a device (11) configured to calculate a corresponding starting current ($I_{max}$) from the measured battery voltage ($U_{minStart}$) by means of a battery model (12),
an apparatus (11) configured to determine at least one characteristic variable ($U_{min}$) in the form of a prediction of an expected on-board power system voltage using the battery model (12) and the calculated starting current ($I_{max}$).

7. Device according to Claim 6, **characterized by** an apparatus (10) configured to update at least one parameter and/or one state variable of the battery model (12).

8. Device according to one of the preceding Claims 6 or 7, **characterized by** an apparatus (10) configured to measure the minimum battery voltage ($U_{minStart}$) during the starting process.

9. Device according to one of the preceding Claims 6 to 8, **characterized by** an apparatus (11) configured to determine the starting current ($I_{max}$) using an internal resistance (Ri) of the battery.

10. Device according to one of the preceding Claims 6 to 9, **characterized by** an apparatus (11) configured to determine an internal resistance (Ri) of the battery by measuring the current ($I_{Batt}$) and the voltage ($U_{Batt}$), preferably just after a time (tp) of occurrence of the minimum battery voltage ($U_{minStart}$).

**Revendications**

1. Procédé de détermination d'une grandeur caractéristique ($U_{min}$) afin de détecter la stabilité du réseau de bord, comprenant les étapes suivantes :

- détection d'un démarrage du moteur,
- acquisition de la tension de batterie ($U_{minStart}$) pendant le démarrage du moteur,
- calcul d'un courant de démarrage ($I_{max}$) correspondant à partir de la tension de batterie ($U_{minStart}$) détectée à l'aide d'un modèle de batterie (12),
- détermination d'au moins une grandeur caractéristique ($U_{min}$) sous la forme d'une prédiction d'une tension de réseau de bord à attendre en utilisant le modèle de batterie (12) et le courant de démarrage (Imax) calculé.

2. Procédé selon la revendication 1, **caractérisé en ce que** dans une étape supplémentaire après la détection du démarrage du moteur, les paramètres et/ou les grandeurs d'état du modèle de batterie (12) sont actualisés.

3. Procédé selon l'une des revendications précédentes, **caractérisé en ce qu'**après la détection du démarrage du moteur, la tension de batterie ($U_{minStart}$) minimale pendant le processus de démarrage est détectée.

4. Procédé selon l'une des revendications précédentes, **caractérisé en ce que** le courant de démarrage ($I_{max}$) est déterminé en utilisant une résistance interne (Ri) de la batterie.

5. Procédé selon l'une des revendications précédentes, **caractérisé en ce que** la résistance interne (Ri) de la batterie est déterminée en détectant le courant ($I_{Batt}$) et la tension ($U_{Batt}$), de préférence très peu de temps après un instant (tp) où se produit la tension de batterie ($U_{minStart}$) minimale.

6. Dispositif de détermination d'une grandeur caractéristique ($U_{min}$) afin de détecter la stabilité du réseau de bord, comprenant :

- un dispositif (10) configuré pour détecter un démarrage du moteur (11),
- un dispositif (10) configuré pour mesurer une tension de batterie ($U_{minStart}$) pendant le démarrage du moteur,
- un dispositif (11) configuré pour calculer un courant de démarrage ($I_{max}$) correspondant à partir de la tension de batterie ($U_{minStart}$) mesurée à l'aide d'un modèle de batterie (12),
- un dispositif (11) configuré pour déterminer au moins une grandeur caractéristique ($U_{min}$) sous la forme d'une prédiction d'une tension de réseau de bord à attendre en utilisant le modèle de batterie (12) et le courant de démarrage ($I_{max}$) calculé.

7. Dispositif selon la revendication 6, **caractérisé par** un dispositif (10) configuré pour actualiser au moins un paramètre et/ou une grandeur d'état du modèle de batterie (12).

8. Dispositif selon l'une des revendications précédentes 6 ou 7, **caractérisé par** un dispositif (10) configuré pour détecter la tension de batterie ($U_{minStart}$) minimale pendant le processus de démarrage.

9. Dispositif selon l'une des revendications précédentes 6 à 8, **caractérisé par** un dispositif (11) configuré pour déterminer le courant de démarrage ($I_{max}$) en utilisant une résistance interne (Ri) de la batterie.

10. Dispositif selon l'une des revendications précédentes 6 à 9, **caractérisé par** un dispositif (11) configuré pour déterminer une résistance interne (Ri) de la batterie en détectant le courant ($I_{Batt}$) et la tension ($U_{Batt}$), de préférence très peu de temps après un instant (tp) où se produit la tension de batterie ($U_{minStart}$) minimale.

**Fig. 1**

EP 2 404 186 B1

**Fig. 2**

| Erkennen Motorstart | —31 |
| Messen U$_{minStart}$ | —32 |
| Berechnung Modellparameter | —33 |
| Berechnung I$_{max}$ | —34 |
| Prädiktion U$_{min}$ | —35 |

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1207297 A2
- DE 10328055 A1
- EP 992801 A
- DE 102005026866 A